# FASCICULE DE BREVET EUROPEEN

(11) **EP 3 304 597 B1**
(45) Date de publication et mention de la délivrance du brevet: **10.07.2019**
(21) Numéro de dépôt: 16726801.0
(22) Date de dépôt: 13.05.2016
(51) Int. Cl.: H01L 27/146, H01L 27/148

(54) **CAPTEUR D'IMAGE A TRANSFERT DE CHARGES A DOUBLE IMPLANTATION DE GRILLE**
LADETRANSERBILDSENSOR MIT DOPPELGATE-IMPLANTIERUNG
CHARGE-TRANSFER IMAGE SENSOR HAVING DOUBLE GATE IMPLANTATION

(30) Priorité: 28.05.2015 FR 1554806
(43) Date de publication de la demande: 11.04.2018
(73) Titulaire: Teledyne e2v Semiconductors SAS, 38120 Saint-Egrève (FR)
(72) Inventeur: MAYER, Frédéric, 38500 Voiron (FR); BARBIER, Frédéric, 38120 Fontanil-Cornillon (FR)
(74) Mandataire: Desvignes, Agnès
(86) Numéro de dépôt international: PCT/EP2016/060900
(87) Numéro de publication internationale: WO 2016/188778

(56) Documents cités:
- WO-A1-2011/144459
- US-A1- 2009 179 232
- US-B1- 6 465 820

## Description

L'invention concerne les capteurs d'image linéaire à défilement et intégration de signal (ou capteurs TDI, de l'anglais : "Time Delay Integration Linear Sensors"), dans lesquels une image d'une ligne de points d'une scène observée est reconstituée par addition d'images successives prises par plusieurs lignes photosensibles observant successivement une même ligne de la scène au fur et à mesure que la scène défile devant le capteur perpendiculairement aux lignes.

Ces capteurs sont utilisés par exemple dans des scanners. Ils comprennent une barrette de plusieurs lignes parallèles de pixels photosensibles ; le séquencement des circuits de commande des différentes lignes (contrôle de temps d'exposition puis de lecture des charges photogénérées) est synchronisé par rapport au défilement relatif de la scène et du capteur, de manière que toutes les lignes du capteur voient successivement une même ligne de la scène observée. Les signaux générés par chaque ligne sont ensuite additionnés point à point pour chaque point de la ligne observée.

A temps d'exposition constant, la sensibilité du capteur est améliorée dans le rapport du nombre N de lignes, ou bien, à sensibilité constante, le temps d'exposition peut être divisé par N. Ce nombre N peut être par exemple de 16 ou 32 pour des applications de contrôle industriel ou des applications d'observation terrestre à partir de l'espace, ou même de 60 à 100 pour des applications médicales (dentaire, mamographie, ...).

Le rapport signal/bruit est amélioré dans le rapport de la racine carrée du nombre N de lignes du capteur.

De plus, les non-uniformités de sensibilité des pixels d'une même barrette, et les non-uniformités de courant d'obscurité des pixels, sont diminuées par suite du moyennage qui résulte de l'addition des signaux des différentes lignes.

Dans les capteurs d'image à transfert de charges (capteurs CCD), l'addition des signaux point par point se faisait naturellement et sans bruit de lecture en vidant dans une ligne de pixels les charges générées et accumulées dans la ligne de pixels précédente, en synchronisme avec le déplacement relatif de la scène et du capteur. La dernière ligne de pixels, ayant accumulé N fois les charges engendrées par la ligne d'image observée, peut être lue.

La technologie habituelle des capteurs d'image CCD utilise des tensions d'alimentation élevées et consomme une énergie importante ; cette technologie est basée sur l'utilisation de grilles de silicium polycristallin adjacentes et en recouvrement mutuel.

La technologie des capteurs d'image a ensuite évolué vers des capteurs à pixels actifs à transistors, qu'on appellera ci-après capteurs CMOS pour simplifier car ils sont en général réalisés en technologie CMOS (complementary-metal-oxyde-semiconducteur) ; dans ces capteurs CMOS il n'y a plus de transfert de charges de ligne en ligne vers un circuit de lecture ou un registre mais il y a des pixels actifs à transistors qui recueillent des charges électriques photogénérées et les convertissent directement en une tension ou un courant. Les différentes lignes du capteur fournissent donc successivement des tensions ou courants représentant l'éclairement reçu par la ligne. Ces structures ne permettent pas de réaliser des sommations sans bruit de ces courants ou tensions ; il est donc difficile de réaliser un capteur à défilement et à intégration de charges. La technologie de fabrication est cependant simple, elle consomme peu, et elle fonctionne sous basse tension.

Des tentatives ont cependant été faites pour réaliser des capteurs CMOS à défilement et intégration de charges. Le document US 2009179232 décrit un capteur de pixel actif CMOS.

On a essayé en particulier d'utiliser des capacités commutées dans lesquelles on intègre des courants successifs reçus, accumulant ainsi sur une même capacité des charges reçues de plusieurs pixels en colonne (US6906749, WO0126382).

On a également proposé de convertir en valeurs numériques les signaux issus d'une ligne de pixels, de sommer la valeur numérique correspondant au pixel de rang j de la ligne dans un registre accumulateur de rang j qui accumule les valeurs numériques correspondant aux pixels de même rang j de N lignes successives (brevet FR2906080).

Des solutions utilisant une accumulation de charges à l'intérieur du pixel ont également été proposées, par exemple dans la publication de brevet US2008/0217661. Elles utilisent une technologie plus complexe que celle qui est strictement nécessaire pour réaliser des capteurs d'image en technologie CMOS, ou bien elles présentent des pertes lors des transferts de charges.

Dans le brevet US6465820 est décrite une structure en technologie CMOS à un seul niveau de grille en silicium polycristallin comprenant une alternance de grilles et de photodiodes. La directionalité du transfert est assurée par deux niveaux d'implantation différents sous une même grille et deux niveaux d'implantation différents dans une même photodiode.

Dans le brevet US8816406 (publication WO 2011/144459 A1) on a proposé un capteur en technologie CMOS à un seul niveau de grille en silicium polycristallin, utilisant une alternance de grilles et de photodiodes. La structure repose sur une dissymétrie des grilles pour imposer une direction de transfert commune à toutes les charges, pour éviter que les charges ne partent aléatoirement dans une direction ou la direction inverse. Les grilles ont d'un côté des doigts très étroits séparés par des régions p++ au potentiel du substrat. L'étroitesse des doigts de grille crée, par influence des régions p++ qui les touchent, une barrière de potentiel plus haute que du côté où il n'y a pas ces doigts étroits. Cette configuration assure la directionalité du transfert de charges.

Dans le brevet US8748954, la directionalité est assurée par une commande conjointe du potentiel des grilles, associée à une commande indépendante du potentiel superficiel des photodiodes.

Dans le brevet US8933495, la directionalité est assurée par le fait que les grilles alimentées par des potentiels différents sont séparées par des photodiodes très étroites dont le potentiel interne est influencé d'une manière différente par une grille qui est au potentiel haut et par une grille qui est au potentiel bas au même moment.

Les structures de l'art antérieur présentent des inconvénients résultant soit d'une complexité de la technologie soit d'une complexité des signaux de commande qui permettent leur fonctionnement.

Les tentatives pour réaliser un capteur linéaire à défilement et intégration de charges utilisant une technologie plus simple que la technologie CCD habituelle n'ont donc pas donné complète satisfaction et un but de l'invention est de proposer une autre solution à ces problèmes.

L'invention a pour but de proposer une solution plus avantageuse pour réaliser des capteurs TDI fonctionnant selon le principe des structures à transfert et addition de charges, utilisant seulement deux phases de commande, et utilisant une technologie compatible avec des circuits de technologie CMOS, notamment une technologie n'utilisant qu'un seul niveau de grille en silicium polycristallin et non un double niveau de grilles en recouvrement mutuel comme c'est le cas dans les technologies CCD classiques.

Selon l'invention, on propose un capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image dans les pixels de même rang des différentes lignes, les pixels adjacents d'une colonne comprenant chacun une photodiode de largeur L_{P} diffusée dans une couche semiconductrice active et une grille de stockage de largeur L_{G} en silicium polycristallin dopé, adjacente à la photodiode du pixel et adjacente à la photodiode d'un pixel suivant, caractérisé en ce que
- la configuration du dopage de la couche active est unique sur toute la largeur L_{P} de la photodiode,
- la configuration du dopage de la couche active est unique sur toute la largeur L_{G} de la grille,
- et la grille en silicium polycristallin comporte deux types de dopage qui sont un premier type de conductivité de type p sur une partie de la largeur L_{G}, du côté où la grille est adjacente à la photodiode du pixel et un deuxième type de conductivité de type n sur une autre partie de la largeur L_{G}, du côté adjacent à la photodiode du pixel suivant, et les deux parties de grille sont portées à un même potentiel par un conducteur métallique en contact avec chaque partie.

Ce double dopage de la grille induit dans la couche active des potentiels différents dans la première partie de la largeur L_{G} et dans la deuxième partie de la largeur L_{G}, pour un même potentiel appliqué à la grille. Cette différence de potentiel crée une marche suffisante pour assurer une directionalité du transfert de charges du pixel vers le pixel suivant lors d'une alternance de potentiels appliqués aux grilles appartenant à ces deux pixels

Le capteur d'image TDI comporte de préférence des moyens pour appliquer aux grilles de deux pixels adjacents, qui sont respectivement un pixel amont et un pixel aval, l'alternance cyclique de potentiels suivante :
- potentiel bas sur les grilles des deux pixels ;
- montée de la grille du pixel amont à un potentiel haut, le potentiel du pixel aval restant bas,
- retour au niveau bas du potentiel de la grille du pixel amont,
- montée de la grille du pixel aval au potentiel haut, le potentiel du pixel amont restant bas,
- retour au niveau bas du potentiel de la grille du pixel aval.

Les potentiels appliqués aux grilles des pixels sont les mêmes pour tous les pixels d'une ligne. Les potentiels appliqués aux grilles des pixels des autres couples de deux lignes adjacentes suivent le même cycle.

Dans une réalisation où les transferts de charges électriques se font en surface de la couche active, les grilles sont disposées au-dessus d'une couche active épitaxiale d'un premier type de conductivité (en principe le type p). Dans une autre réalisation, où les transferts de charges électriques se font en volume, la partie supérieure de la couche active épitaxiale est uniformément dopée d'un type opposé (n) sous les grilles de tous les pixels, la partie inférieure de la couche épitaxiale étant dopée du premier type (p). Dans les deux cas, la photodiode est formée par une diffusion d'un deuxième type de conductivité (n) s'étendant jusqu'à la région dopée du premier type de la couche active épitaxiale. La photodiode est de préférence une photodiode autopolarisée ou photodiode "pinned", c'est-à-dire qu'elle est recouverte d'une couche superficielle du premier type de conductivité, reliée au même potentiel de référence auquel est portée la couche active.

Dans tous les cas, la structure du dopage dans la photodiode est la même tout le long de la largeur L_{P} de la photodiode (dans le sens perpendiculaire aux lignes de pixels, c'est-à-dire dans le sens du défilement du capteur par rapport à l'image) ; et la structure du dopage de la couche active épitaxiale est la même tout le long de la largeur L_{G} de la grille, dans le même sens.

D'autres caractéristiques et avantages de l'invention apparaîtront à la lecture de la description détaillée qui suit et qui est faite en référence aux dessins annexés dans lesquels :
- la figure 1 représente la structure générale, connue, d'un capteur d'image matriciel à défilement et intégration de charges ;
- la figure 2 représente une coupe de la constitution physique des pixels dans une réalisation de l'art antérieur ;
- la figure 3 représente une coupe de la constitution physique du capteur selon l'invention ;
- la figure 4 représente la même structure, avec une indication de la position du contact des grilles de silicium polycristallin avec un conducteur d'amenée de potentiel aux grilles ;
- la figure 5 représente une variante de réalisation de l'invention, dans le cas d'un transfert de charges en volume ;
- la figure 6 représente un diagramme d'évolution des potentiels au cours d'un cycle de transfert de charges.

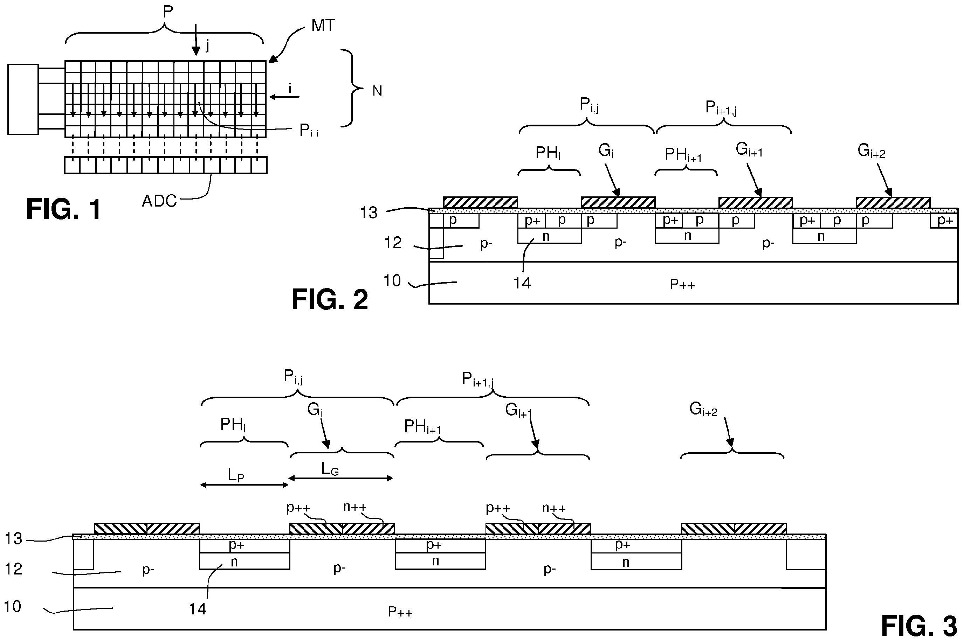

Sur la figure 1, on voit l'architecture générale d'un capteur d'image à transfert de charges. Le capteur comporte une matrice MT de N lignes de P pixels sensibles à la lumière. Les charges résultant de l'éclairement d'un pixel P_{i,j} de rang i en ligne et j en colonne sont intégrées dans le pixel pendant une durée d'intégration T ; puis elles sont transférées dans le pixel de la ligne suivante de rang i+1 en ligne et de même rang j en colonne ; les pixels adjacents dans le sens des colonnes (sens vertical sur la figure) sont agencés en registre à décalage vertical à transfert de charges.

Le capteur est un capteur linéaire à défilement et intégration de charges ; on accumule les charges lues par les N pixels d'une colonne pendant N durées d'intégration successives, en synchronisme avec le défilement de l'image devant le capteur. Chacune des N lignes de pixels voit successivement une même ligne d'image au cours du défilement de l'image par rapport au capteur ; les charges intégrées dans une ligne de rang i, qui correspondent à une ligne d'image observée, sont additionnées dans les pixels de cette ligne aux charges précédemment lues par les i-1 lignes précédentes qui ont vu la même ligne d'image pendant les durées d'intégration précédentes. Au bout de N durées d'intégration, la dernière ligne de pixels contient la somme des charges recueillies par toutes les lignes qui ont vu la même ligne d'image. Ces charges sont converties en numérique à la fin de chaque durée T par des convertisseurs analogique-numérique ADC en pied de colonne.

La vue en coupe de la figure 2 représente un exemple de réalisation physique du schéma de la figure 1, dans lequel un pixel comporte simplement deux régions adjacentes dans le sens du transfert de charges, c'est-à-dire dans le sens d'une colonne de la matrice ; ces régions sont une photodiode et une grille de stockage et de transfert. La coupe de la figure 2 est une coupe le long d'une colonne de pixels et elle montre deux pixels successifs de même rang j en colonne, respectivement P_{i,j} appartenant à une ligne de rang i et P_{i+1,j} appartenant à une ligne de rang i+1.

Les pixels sont formés dans un substrat semiconducteur 10 dont la partie supérieure est une couche active semiconductrice épitaxiale peu dopée 12. Dans cet exemple, le substrat est de type p++ fortement dopé, et la couche active épitaxiale est de type peu dopée (p-). Si la couche épitaxiale était de type n, il faudrait inverser tous les types de conductivité, ainsi que les signes des potentiels appliqués aux photodiodes et aux grilles. Le substrat est en principe de même type de conductivité que la couche épitaxiale, mais il pourrait également être de type opposé.

Les colonnes comportent une alternance régulière de photodiodes et de grilles de stockage de charges.

Les grilles des pixels sont commandées périodiquement avec une période T et les signaux qui leur sont appliqués permettent aux charges générées par la lumière d'être recueillies et transférées progressivement d'un pixel au suivant. Un même signal de commande est appliqué à tous les pixels d'une même ligne et les grilles sont en pratique des lignes de grille qui s'étendent perpendiculairement aux colonnes donc perpendiculairement au plan de la figure 2.

Un pixel P_{i,j} de rang i en ligne comporte une photodiode PHᵢ et une grille de stockage de charges Gᵢ. Les grilles sont des grilles de silicium polycristallin, isolées de la couche épitaxiale 12 par une fine couche isolante 13 (oxyde ou nitrure de silicium). Les photodiodes sont réalisées par une diffusion 14 de type n formée entre deux grilles adjacentes appartenant à deux pixels voisins. La partie supérieure des photodiodes comporte de préférence, pour des photodiodes autopolarisées, un dopage superficiel de type p maintenu au potentiel de référence de la couche active épitaxiale 12. Le dopage superficiel est plus élevé que celui de la couche active.

Les électrons générés par l'éclairement pourront s'accumuler dans des puits de potentiel formés à la jonction entre la région n et la couche épitaxiale p-.

Dans cette structure de l'art antérieur, la directionalité du transfert est assurée par la présence de deux dopages différents de la couche semiconductrice sous la grille et deux dopages différents de la partie superficielle de la photodiode. Ces dopages différents créent des marches de potentiel dans la couche active, et ces marches assurent que les charges stockées sous une grille ou sous une photodiode se déversent toujours dans le même sens (ici : du haut vers le bas de la colonne, de la gauche vers la droite de la figure 2) lorsque les grilles subissent une alternance de potentiels hauts et bas.

Plus précisément, pour assurer un transfert de la gauche vers la droite, cette réalisation prévoit que la partie gauche de la couche épitaxiale sous la grille Gᵢ contient une concentration d'impuretés de type p supérieure à la concentration faible p- de la couche épitaxiale. De plus, la partie gauche du dopage superficiel de la photodiode contient également plus d'impuretés de type p que la partie droite de cette même couche. Cette disposition avec un dopage différent entre la gauche et la droite de la couche épitaxiale sous la grille et un dopage différent entre la gauche et la droite de la partie supérieure de la photodiode est répétée pour tous les pixels. Lorsque les grilles des pixels subissent une alternance de potentiels hauts et bas, les charges électriques générées par la lumière passent successivement de la jonction d'une photodiode d'un pixel vers la région située sous la grille de ce pixel, puis de cette région vers la jonction de la photodiode du pixel suivant, puis vers la région sous la grille de ce pixel suivant, etc., toujours de la gauche vers la droite.

La fabrication d'une telle structure, et plus particulièrement de ces dopages différents sous la grille et dans la photodiode est difficile.

Selon l'invention, on propose une structure beaucoup plus simple à réaliser, permettant un transfert de charges directionnel sur toute la colonne sans nécessiter plus de deux phases de commande des grilles des pixels au cours du cycle d'intégration et transfert de charges.

La figure 3 représente une structure de capteur à défilement et intégration de charges selon l'invention. La coupe est établie selon le même principe qu'à la figure 2 et les éléments de même fonction sont désignés par les mêmes références et ne seront pas décrits à nouveau. La configuration du dopage de la couche épitaxiale sous les grilles est maintenant unique (c'est le dopage de la couche active épitaxiale) lorsqu'on se déplace de la gauche vers la droite sur toute la largeur L_{G} de la grille, contrairement au cas de la figure 2 où il y a deux configurations de dopage (dopage p et dopage p-) ; de même, la configuration du dopage dans la photodiode est unique lorsqu'on se déplace de la gauche vers la droite, c'est-à-dire qu'il y a un seul dopage de type n sur toute la largeur L_{P} de la photodiode et un seul dopage superficiel p à la partie supérieure sur toute cette largeur L_{P}, par opposition au cas de la figure 2 où la partie gauche (p+) est dopée différemment de la partie droite (p).

Mais la grille de silicium polycristallin comporte deux dopages différents, l'un à gauche là où la grille du pixel est adjacente à la photodiode du pixel, l'autre à droite, là où la grille du pixel est adjacente à la photodiode du pixel de rang suivant. Le dopage sur la partie gauche, c'est-à-dire du côté amont dans le sens de déplacement des charges électriques lors d'un transfert de pixel à pixel, est de type p, noté p++ car le dopage est fort pour donner une forte conductivité à cette partie de la grille. Le dopage sur la partie droite, du côté aval, est de type n, noté n++ car le dopage est fort pour la même raison.

Les deux parties de la grille sont portées au même potentiel. De même que les grilles des structures de l'art antérieur peuvent recevoir un potentiel de commande par un contact (non représenté car il n'est pas nécessairement dans le plan de coupe de la figure 2) entre une grille et un conducteur métallique (en aluminium par exemple), on pourra également prévoir que les grilles à double dopage de l'invention reçoivent un potentiel de commande par un contact entre la grille et un conducteur métallique et il faut alors que le conducteur métallique touche à la fois la partie gauche et la partie droite de la grille pour assurer un contact à la fois avec la partie dopée de type p++ et avec la partie dopée de type n++.

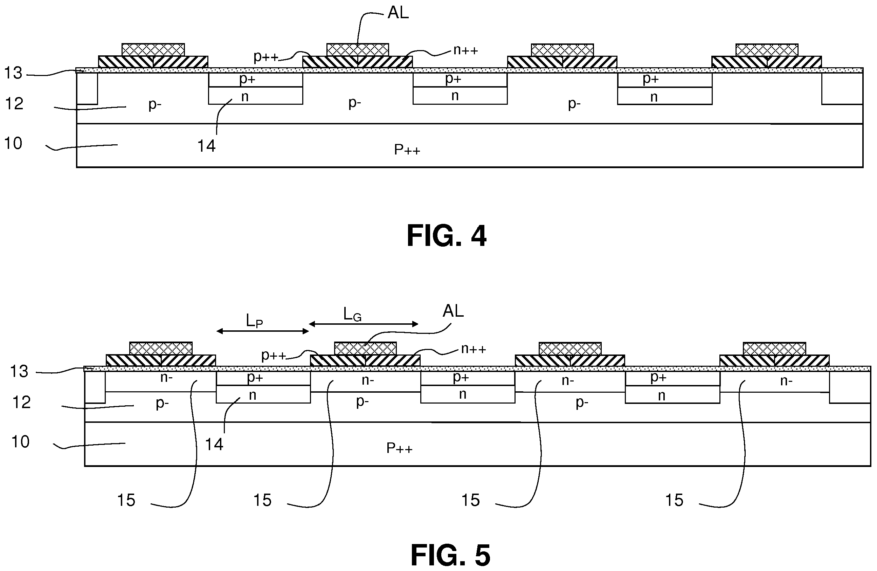

Sur la figure 4, on a représenté une possibilité de réalisation dans laquelle des conducteurs d'aluminium AL sont disposés au-dessus des lignes de silicium polycristallin qui s'étendent le long des lignes de pixels. Ces conducteurs d'aluminium viennent en contact de place en place avec les lignes de grilles, et à l'endroit de ces contacts ils touchent à la fois la partie dopée p++ et la partie dopée n++ de la grille. Ces contacts ne sont pas nécessairement dans le plan de coupe de la figure.

Dans une variante de réalisation, on prévoit que toute la surface de la couche active épitaxiale est dopée avec une impureté de type opposé au substrat, et ceci sur toute la matrice de pixels. Lorsque la couche épitaxiale est de type p- depuis sa surface jusque dans sa partie inférieure, comme c'est représenté aux figures 3 et 4, le profil des potentiels dans cette couche est tel que les charges électriques se déplacent à la surface de la couche, c'est-à-dire à l'interface entre le silicium de la couche épitaxiale et le diélectrique 13 qui recouvre cette couche. Cette solution n'est pas la meilleure à cause des risques de piégeage de charges dans cette interface. Le piégeage résulte des défauts de surface et risque de provoquer des transfert de charges incomplets d'un pixel à l'autre.

Dans la variante de la figure 5, qui reprend les mêmes éléments qu'à la figure 4, on a prévu en outre une couche uniforme superficielle 15 de type n (type opposé à la couche active épitaxiale) à la partie supérieure de la couche épitaxiale. La présence de cette couche modifie les profils de potentiel engendrés par les tensions appliquées aux grilles, et le nouveau profil repousse légèrement vers l'intérieur de la couche épitaxiale les charges transférées. Les risques de piégeage de charges sont éliminés. La couche 15 est notée n- car elle est moins dopée que la région 14 de la photodiode (notée n).

Là encore, la configuration du dopage sous la grille reste unique sur toute la largeur L_{G} de la grille (dopage n- surmontant le dopage p- de la couche épitaxiale), et la configuration du dopage dans la photodiode reste unique sous toute la largeur L_{P} de la photodiode (dopage p+ surmontant le dopage n de la photodiode, lui-même surmontant le dopage p- de la couche épitaxiale).

Les marches de potentiel engendrées par les deux dopages opposés p++ et n++ des grilles sont présentes dans la couche 15 de type n-comme elles étaient présentes à la surface de la couche active p- dans le cas des figures 3 et 4.

Le cycle de fonctionnement normal de ce capteur est de préférence un cycle dans lequel les potentiels appliqués à deux pixels adjacents suivent l'évolution suivante : les potentiels sont d'abord bas pour les grilles des deux pixels, puis haut pour l'une d'elles, puis à nouveau bas pour les deux, puis haut pour l'autre grille, et enfin retour au début de cycle avec des potentiels bas pour toutes les grilles. Les charges se transfèrent alors d'abord d'une photodiode d'un pixel amont vers la grille de ce pixel, puis de cette grille vers la photodiode du pixel aval, puis de la photodiode du pixel aval vers la grille du pixel aval.

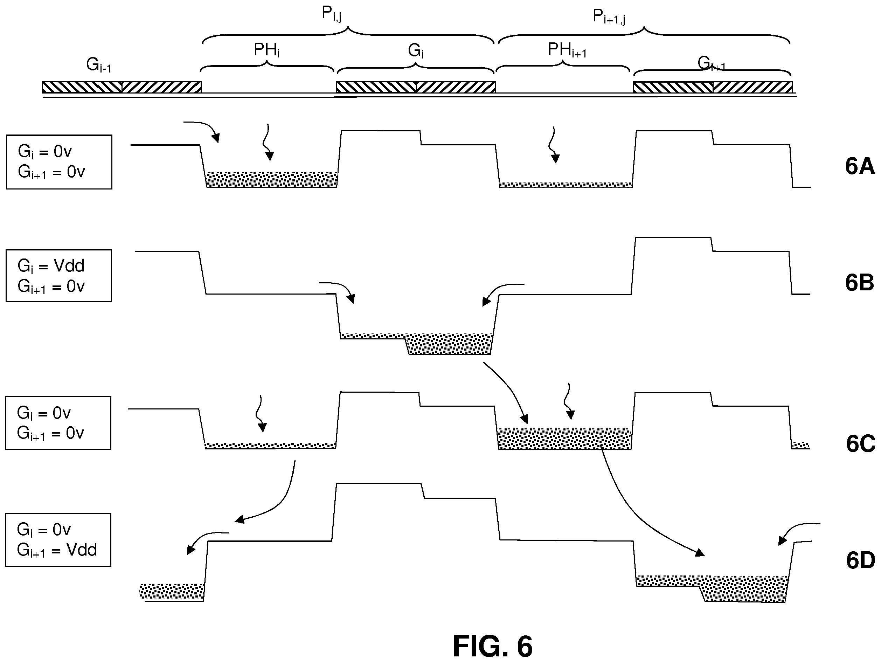

Ce cycle donne lieu à un diagramme de variations de potentiels dans la couche épitaxiale qui est indiqué sur la figure 6. Les potentiels appliqués aux grilles sont soit un potentiel bas 0 volt qui peut être celui du substrat du capteur, soit un potentiel haut, par exemple égal au potentiel d'alimentation Vdd du capteur.

On peut partir d'un état dans lequel les grilles de rang impair Gᵢ₋₁, Gᵢ₊₁ ... passent au potentiel bas alors que les grilles de rang pair Gᵢ, Gᵢ₊₂ sont déjà au potentiel bas. Ligne 6A. Des puits de potentiel sous les photodiodes accumulent des charges qui proviennent de l'éclairement de ces photodiodes par une ligne d'image ; les photodiodes des pixels de rang pair contiennent en outre des charges résultant du déversement en provenance de pixels situés en amont et qui correspondent à l'éclairement d'autres photodiodes par la même ligne d'image au fur et à mesure du défilement.

On fait alors passer les grilles de rang pair au potentiel haut Vdd. Ligne 6B. Les charges accumulées situées dans la photodiode amont PHᵢ de rang pair et les charges récentes situées dans la photodiode aval de rang impair Gᵢ₊₁ se déversent sous la grille Gᵢ de rang pair qu'elles encadrent.

On ramène ensuite à 0 le potentiel des grilles de rang pair. Ligne 6C. Les charges accumulées présentes sous la grille Gᵢ de rang pair se déversent dans la photodiode PHᵢ₊₁ du pixel situé en aval. La photodiode PHᵢ recommence à accumuler des charges (d'une ligne d'image suivante).

Puis, on fait passer à Vdd le potentiel des grilles de rang impair tout en gardant à 0 le potentiel des grilles de rang pair. Ligne 6D. Les charges stockées dans la photodiode PHᵢ₊₁, résultant du déversement précédent et résultant de l'éclairement par la ligne d'image, passent sous la grille Gᵢ₊₁.

Dans ces quatre étapes qui sont renouvelées ensuite cycliquement, les charges accumulées résultant d'une ligne d'image sont transférées d'un pixel amont à un pixel aval en y rajoutant à chaque fois les charges courantes générées par la ligne d'image.

Le double dopage de la grille assure la formation d'une barrière de potentiel qui favorise un sens unique de déversement de charges de l'amont vers l'aval.

La fabrication du capteur TDI selon l'invention est particulièrement simple en raison de l'unicité du dopage dans la couche épitaxiale dans toute la largeur L_{G} de la grille et de l'unicité du dopage dans toute la largeur L_{P} de la photodiode.

Cette fabrication comprend les étapes suivantes :
- formation de la couche épitaxiale p- sur le substrat de type p++ ;
- dopage uniforme de type n- à la surface de la couche épitaxiale (dans le cas où on veut un transfert en volume : cas de la figure 5) ;
- formation de la couche isolante 13 (oxyde de grille) sur toute la surface de la matrice de pixels ;
- dépôt d'une couche de silicium polycristallin sur toute la surface de la matrice ; le silicium polycristallin peut être dopé de type n ou de type p ;
- photolithographie d'un motif de masquage pour protéger soit les parties gauches soit les parties droites des grilles à réaliser, par exemple les parties gauches qui doivent être de type p++ ;
- implantation d'une impureté du type opposé (n++ dans ce cas) dans les parties non protégées, c'est-à-dire dans ce qui deviendra les parties droites des grilles ;
- nouvelle photolithographie d'un motif de masquage pour protéger les parties droites et dégager les parties gauches ;
- implantation d'une impureté p++ dans ce qui deviendra les parties gauches des grilles.

On notera que ces deux photolithographies définissent les frontières séparant les régions p++ des régions n++ ; l'une de ces frontières sera située au-dessus des photodiodes et disparaîtra lors de la gravure des grilles auto-alignées avec les photodiodes ; cette frontière n'a donc pas besoin d'être précise, pourvue qu'elle soit située à l'endroit d'une photodiode ; l'autre frontière sera la frontière subsistant après gravure des grilles, visible sur les figures 3 à 5 ; elle est située à un endroit de la grille qui n'a pas besoin d'être précis par rapport aux limites des photodiodes ; cet endroit peut être aux alentours du milieu de la largeur L_{G} de la grille.

On notera aussi que l'une des implantations (et donc la photolithographie correspondante) peut être facultative dans le cas où on a fortement dopé de type n++ ou p++ le silicium polycristallin au moment de son dépôt. Cependant, dans ce cas, l'implantation qui réalise l'autre dopage de la grille (p++ ou n++ respectivement) doit être faite avec une concentration d'impuretés particulièrement importante car il faut alors compenser un dopage déjà fort de type n++ ou p++.

Après les étapes de dopage différentiel des grilles, il reste à définir le motif de grilles : ce motif est défini par gravure du silicium polycristallin qu'on enlève à l'endroit où on implantera les dopages des photodiodes.

Après gravure des grilles, on implante l'impureté de type n des photodiodes, auto-alignée par rapport aux grilles qui servent de masques lors de cette implantation. Cette implantation rajoute un peu d'impureté de type n dans les parties droite n++ des grilles et compense en partie (mais faiblement) le type p++ des parties gauche.

Puis on implante la couche superficielle de type p+ des photodiodes, toujours avec un masquage par les grilles. Là encore, cette implantation n'affecte que très peu la concentration en impuretés des parties gauche et droite des grilles.

Les étapes ultérieures sont classiques. Des dépôts et gravures d'isolants et de couches d'aluminium peuvent être effectuées, la seule particularité étant que le motif de couche d'aluminium qui vient en contact avec les grilles doit contacter à la fois les parties p++ et les parties n++ des grilles pour leur appliquer un même potentiel.

## Revendications

1. Capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image dans les pixels de même rang des différentes lignes, les pixels adjacents d'une colonne comprenant chacun une photodiode (PHᵢ) de largeur L_{P} diffusée dans une couche semiconductrice active (12) et une grille de stockage (Gᵢ) de largeur L_{G} en silicium polycristallin dopé, adjacente à la photodiode du pixel et adjacente à la photodiode (PHᵢ₊₁) d'un pixel suivant de la colonne, **caractérisé en ce que**
- la configuration du dopage de la couche active est unique sur toute la largeur L_{P} de la photodiode,
- la configuration du dopage de la couche active est unique sur toute la largeur L_{G} de la grille,
- et la grille en silicium polycristallin comporte deux types de dopage qui sont un dopage d'un premier type de conductivité sur une partie de la largeur L_{G}, du côté où la grille est adjacente à la photodiode du pixel et un dopage d'un type de conductivité opposé sur une autre partie de la largeur L_{G}, du côté adjacent à la photodiode du pixel suivant, les deux parties étant portées au même potentiel par un conducteur métallique qui vient en contact avec chaque partie.

2. Capteur d'image selon la revendication 1, **caractérisé en ce qu'**il comporte un circuit de commande configuré pour appliquer aux grilles de deux pixels adjacents qui sont respectivement un pixel amont et un pixel aval l'alternance cyclique de potentiels suivante :
- potentiel bas sur les grilles des deux pixels ;
- montée de la grille du pixel amont à un potentiel haut, le potentiel du pixel aval restant bas,
- retour au niveau bas du potentiel de la grille du pixel amont,
- montée de la grille du pixel aval au potentiel haut, le potentiel du pixel amont restant bas,
- retour au niveau bas du potentiel de la grille du pixel aval.

3. Capteur d'image selon la revendication 1 ou 2, **caractérisé en ce que** les grilles de silicium polycristalllin sont disposées au-dessus d'une couche semiconductrice active d'un premier type de conductivité.

4. Capteur d'image selon la revendication 1 ou 2, **caractérisé en ce que** les grilles de silicium polycristalllin sont disposées au-dessus d'une couche superficielle formée en partie supérieure (15) de la couche semiconductrice active et dopée avec un type de conductivité opposé à celui de la couche semiconductrice active.

## Patentansprüche

1. Ladungsübertragungs-Bildsensor, arbeitend mit Durchlauf und Integration von Ladungen, wobei der Bildsensor N aneinandergrenzende Zeilen mit P Pixeln zur Beobachtung einer selben Bildzeile nacheinander durch mehrere Pixel-Zielen mit einer Summierung der durch einen Bildpunkt in den Pixeln gleichen Ranges zwischen den unterschiedlichen Zeilen erzeugten elektrischen Ladungen beinhaltet, wobei die angrenzenden Pixel einer Spalte jeweils eine Photodiode (PHᵢ) mit einer Breite L_{P} beinhalten, welche in eine aktive Halbleiterschicht (12) gestreut ist, und ein Speicherraster (Gᵢ) mit einer Breite L_{G} aus dotiertem, polykristallinem Silizium, welche an die Photodiode des Pixels angrenzt und an die Photodiode (PHᵢ₊₁) eines folgenden Pixels der Spalte angrenzt, **dadurch gekennzeichnet, dass**
- die Konfiguration der Dotierung der aktiven Schicht einheitlich über die gesamte Breite L_{P} der Photodiode ist,
- die Konfiguration der Dotierung der aktiven Schicht einheitlich über die gesamte Breite L_{G} des Rasters ist,
- und das Raster aus polykristallinem Silizium zwei Arten von Dotierung beinhaltet, bestehend aus einer Dotierung einer ersten Art von Leitfähigkeit über einen Teil der Breite L_{G}, auf derjenigen Seite, an der das Raster an die Photodiode des Pixels angrenzt, und eine Dotierung einer gegensätzlichen Art von Leitfähigkeit über einen anderen Teil der Breite L_{G}, auf derjenigen Seite, welche an die Photodiode des folgenden Pixels angrenzt, wobei beide Teile durch einen metallenen Leiter, der mit jedem Teil in Kontakt geht, auf dasselbe Potenzial gebracht werden.

2. Bildsensor nach Anspruch 1, **dadurch gekennzeichnet, dass** er einen Steuerschaltkreis beinhaltet, welcher konfiguriert ist, um an die Raster zweier aneinander grenzender Pixel, welche jeweils ein vorgelagerter und ein nachgelagerter Pixel sind, folgenden zyklischen Wechsel von Potenzialen anzulegen:
- niedriges Potenzial an den Rastern der beiden Pixel;
- Anstieg des Rasters des vorgelagerten Pixels auf ein hohes Potenzial, wobei das Potenzial des nachgelagerten Pixels niedrig bleibt,
- Rückkehr zum niedrigen Potenzialpegel des Rasters des vorgelagerten Pixels,
- Anstieg des Rasters des nachgelagerten Pixels auf das hohe Potenzial, wobei das Potenzial des vorgelagerten Pixels niedrig bleibt,
- Rückkehr zum niedrigen Potenzialpegel des Rasters des nachgelagerten Pixels.

3. Bildsensor nach Anspruch 1 oder 2, **dadurch gekennzeichnet, dass** die Raster aus polykristallinem Silizium oberhalb einer aktiven Halbleiterschicht einer ersten Art von Leitfähigkeit angeordnet sind.

4. Bildsensor nach Anspruch 1 oder 2, **dadurch gekennzeichnet, dass** die Raster aus polykristallinem Silizium oberhalb einer oberflächlichen Schicht angeordnet sind, welche im oberen Teil (15) der aktiven Halbleiterschicht gebildet ist und mit einer zur Leitfähigkeit der aktiven Halbleiterschicht gegensätzlichen Art von Leitfähigkeit dotiert ist.

## Claims

1. Charge transfer image sensor operating by time delay and charge integration, the sensor comprising N adjacent lines of P pixels with a view to an observation of one and the same image line successively by several lines of pixels with a summation of the electric charges generated by an image point in the pixels of the same rank of the various lines, the adjacent pixels of a column each comprising a photodiode (PHᵢ) of width L_{P} diffused in an active semiconducting layer (12) and a storage gate (Gᵢ) of width L_{G} made of doped polycrystalline silicon, adjacent to the photodiode of the pixel and adjacent to the photodiode (PHᵢ₊₁) of a following pixel of the column, **characterized in that**
- the configuration of the doping of the active layer is unique over the whole width L_{P} of the photodiode,
- the configuration of the doping of the active layer is unique over the whole width L_{G} of the gate,
- and the polycrystalline silicon gate comprises two types of doping which are a doping of a first type of conductivity over a part of the width L_{G}, on the side where the gate is adjacent to the photodiode of the pixel, and a doping of an opposite type of conductivity over another part of the width L_{G}, on the side adjacent to the photodiode of the following pixel, the two parts being carried to the same potential by a metallic conductor which comes into contact with each part.

2. Image sensor according to claim 1, **characterized in that** it comprises a drive circuit configured to apply to the gates of two adjacent pixels, which are respectively an upstream pixel and a downstream pixel, the following cyclic alternation of potentials:
- low potential on the gates of both pixels;
- raising of the gate of the upstream pixel to a high potential, the potential of the downstream pixel remaining low,
- return to the low level of the potential of the gate of the upstream pixel,
- raising of the gate of the downstream pixel to the high potential, the potential of the upstream pixel remaining low,
- return to the low level of the potential of the gate of the downstream pixel.

3. Image sensor according to claim 1 or 2, **characterized in that** the polycrystalline silicon gates are disposed above an active semiconducting layer of a first type of conductivity.

4. Image sensor according to claim 1 or 2, **characterized in that** the polycrystalline silicon gates are disposed above a surface layer formed in the upper part (15) of the active semiconducting layer and doped with a type of conductivity opposite to that of the active semiconducting layer.
